# EUROPEAN PATENT SPECIFICATION

(11) **EP 2 589 989 B1**
(45) Date of publication and mention of the grant of the patent: **14.04.2021**
(21) Application number: 12191263.8
(22) Date of filing: 05.11.2012
(51) Int. Cl.: G01V 3/15, H03B 21/00, H03K 3/00

(54) **SIGNAL GENERATOR**
SIGNALERZEUGER
GÉNÉRATEUR DE SIGNAL

(30) Priority: 04.11.2011 GB 201119165; 04.11.2011 US 201113289945
(43) Date of publication of application: 08.05.2013
(73) Proprietor: RADIODETECTION LIMITED, Bristol BS14 0AZ (GB)
(72) Inventor: Pearson, Richard David, Bristol, Somerset BS8 4RB (GB); Lanfranchi, Luigi, Coxley Near Wells, Somerset BA5 1QZ (GB)
(74) Representative: Condon, Neil

(56) References cited:
- EP-A1- 1 657 822
- EP-A2- 0 393 359
- JP-A- S5 845 548
- JP-A- S5 940 287
- US-A1- 2010 321 570
- US-B1- 6 411 073

## Description

### FIELD OF THE DISCLOSED SUBJECT MATTER

The disclosed subject matter relates to signal generators for use in detecting a current carrying conductor.

### BACKGROUND

Before commencing excavation or other work where electrical cables, fiber optic cables or other utilities ducts or pipes are buried, it is important to determine the location of such buried cables or pipes to ensure that they are not damaged during the work. It is also useful to be able to track a path of buried cables or pipes. Current carrying conductors emit electromagnetic radiation which can be detected by an electromagnetic antenna. If fiber optic cables or non-metallic utilities ducts or pipes are fitted with a small electrical tracer line, an alternating electrical current can be coupled into the tracer line which in turn radiates electromagnetic radiation. It is known to use detectors to detect the electromagnetic field emitted by conductors carrying alternating current.

One type of such detector works in one of three modes. These modes are classified as either passive or active modes, the passive modes being 'power' mode and 'radio' mode which use signals that are already present - mains power signals and submarine VLF (very low frequency) communications. Each mode has its own frequency band of detection.

Aspects of the disclosed subject matter relate to the active mode.

In the active mode, a signal transmitter couples an alternating magnetic field of known frequency and modulation, in a buried conductor. The signal transmitter may be directly connected to the conductor. Where direct connection access is not possible, a signal transmitter may be placed near to the buried conductor and an alternating current signal may be induced in the conductor by an alternating magnetic field produced by the signal generator. The buried conductor radiates an alternating magnetic field corresponding to the signal produced by the signal transmitter.

The choice of signal frequency is an important factor for effective tracing and identification of buried lines, and there is no single frequency that covers all conditions. For single instruments to be used by relatively non-technical personnel there is no option but to make a compromise, and choose a single frequency high enough to give good performance in the induction mode, but not so high that it will not travel far enough. Active signals between 8 kHz and 33 kHz are commonly used for these applications.

33 kHz is considered to be a good general purpose signal frequency suitable for finding many buried cables and metallic pipes. For short lengths of cable, for example telecom spurs crossing a subscriber's premises, a signal frequency of 33kHz does not provide sufficient signal to give a good quality locate. This is because the signal return path impedance is high, being predominantly capacitive; the shorter the cable, the lower the capacitance to earth and hence the higher the impedance at a particular frequency. The high impedance results in a small current in the cable.

In this situation a better locate signal quality can be obtained using a higher signal frequency. Multi-frequency locators and transmitters are available having suitable high frequency operating modes, e.g. 66kHz, 83kHz and 131kHz. These products require the operator to select a suitable signal frequency, necessitating a higher degree of operator training and greater expertise than possessed by typical users. Dedicated single-frequency locators exist that are optimised for finding telecoms cables, but these are less well suited to general cable and pipe locating as high frequency signals dissipate rapidly with distance along a typical cable or pipe

US6411073 discloses a signal generator that directly couples a transmission signal onto a metal line. One pole of the generator is connected to the metal line and the other pole to a grounding device. The transmission signal has a carrier frequency modulated with a signal of a lower frequency.

### SUMMARY

The invention relates to a signal generator according to claim 1.

Signal generators according to the disclosed subject matter allow alternating currents having two frequencies to be induced in a concealed conductor. The two frequencies may for example be 33kHz and 66kHz. The frequencies may be detected contemporaneously with each other. Thus an apparatus for locating a concealed conductor may use both frequencies at approximately the same time to locate a conductor. Thus embodiments of the present invention provide for the location of cables or pipes in a wide variety of situations without the need for a user to adjust make adjustments to either the signal generator or the locator. Embodiments of the present invention thus facilitate a robust and accurate system for locating pipes and cables which does not require knowledge by or training for a user.

In an embodiment of the disclosed subject matter, the second frequency is a harmonic of the first frequency. In an embodiment, the second frequency is twice the first frequency

In an embodiment of the disclosed subject matter, the first waveform is selected to suppress a third harmonic frequency of the first frequency. Because the waveform generated is an odd function, it will generally have a large component in the third harmonic. Since this component is the closest of all of the harmonic components (i.e. 3^{rd}, 5^{th}, 7^{th} harmonics) it will have the largest portion that is allowed to pass through the first filter. By suppressing the third harmonic component the generated signal can be made to be a good approximation to a signal containing a single component at the desired frequency.

In an embodiment of the disclosed subject matter, a power supply provides a supply voltage and a ground reference voltage for the first and second oscillators. The first and/or the second oscillator may comprise a current sensor and the power supply is configured to reduce the supply voltage if a current detected by the current sensor exceeds a predetermined value. Such a configuration will save battery power if the impedance between terminals through an external circuit is low as the current flowing through a load applied to the circuit is regulated to maintain the current at or below a maximum value.

In an embodiment of the disclosed subject matter, the signal generator further comprises a first amplifier configured to amplify the first waveform and a second amplifier configured to amplify the second waveform. The first amplifier and /or the second amplifier may comprise two switching elements arranged in a half-bridge formation. The switching elements may be MOSFET devices.

The first and second waveforms may be provided by a controller which is configured to generate the first waveform and the second waveform.

In an embodiment of the disclosed subject matter, the first filter is configured to provide a path to the ground reference from the first terminal for a signal of the second frequency. In an embodiment, the second filter is configured to provide a path to ground from the second terminal for a signal of the first frequency.

In an embodiment of the disclosed subject matter, the first filter and/or the second filter is a band pass filter.

The signal generator may be connected to a concealed conductor by connecting one of the first and second terminals to the buried conductor and for connecting the other of the first and second terminals to Earth.

In an embodiment of the disclosed subject matter, the switching circuit comprises four switching devices in an H-bridge formation.

There has thus been outlined, rather broadly, certain embodiments of the disclosed subject matter in order that the detailed description thereof herein may be better understood, and in order that the present contribution to the art may be better appreciated. There are, of course, additional embodiments of the disclosed subject matter that will be described below and which will form the subject matter of the claims appended hereto.

In this respect, before explaining at least one embodiment of the disclosed subject matter in detail, it is to be understood that the disclosed subject matter is not limited in its application to the details of construction and to the arrangements of the components set forth in the following description or illustrated in the drawings. The disclosed subject matter is capable of embodiments in addition to those described and of being practiced and carried out in various ways. Also, it is to be understood that the phraseology and terminology employed herein, as well as the abstract, are for the purpose of description and should not be regarded as limiting.

As such, those skilled in the art will appreciate that the conception upon which this disclosure is based may readily be utilized as a basis for the designing of other structures, methods, and systems for carrying out the several purposes of the disclosed subject matter. The scope of protection is solely defined by the claims.

### BRIEF DESCRIPTION OF THE DRAWINGS

Embodiments of the disclosed subject matter are illustrated by way of example with reference to the drawings in which:
Fig. 1 illustrates a schematic view of a signal generator according to an embodiment of the disclosed subject matter;
Fig. 2 illustrates a schematic view of a signal generator according to an embodiment of the disclosed subject matter;
Fig. 3A illustrates a schematic view of a signal generator according to an embodiment of the disclosed subject matter;
Fig. 3B illustrates a power supply circuit for a signal generator according to an embodiment of the disclosed subject matter;
Fig. 4A illustrates a drive waveform for use with an embodiment of the disclosed subject matter;
Fig. 4B illustrates a drive waveform for use with an embodiment of the disclosed subject matter;
Fig. 4C illustrates a drive waveform for use with an embodiment of the disclosed subject matter;
Fig. 5 illustrates a locator according to an embodiment of the disclosed subject matter;
Fig. 6A illustrates a schematic view of a locator according to an embodiment of the disclosed subject matter; and
Fig. 6B illustrates a schematic view of a locator according to an embodiment of the disclosed subject matter.

### DETAILED DESCRIPTION

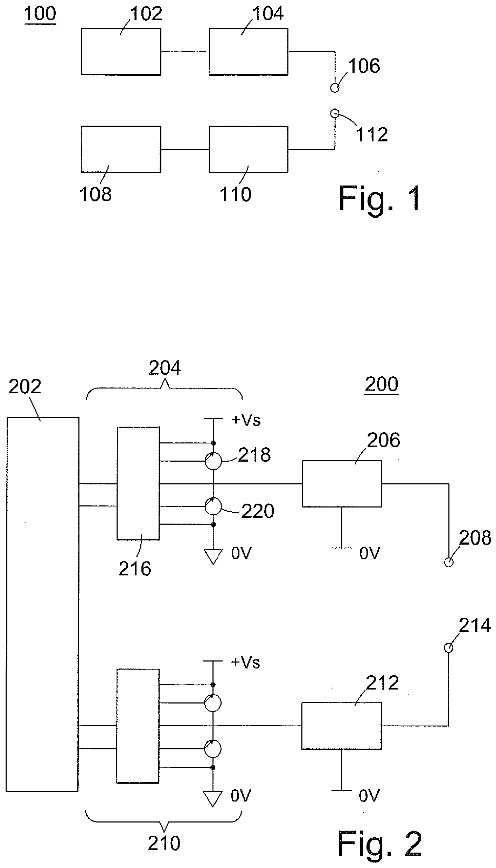

Fig. 1 illustrates a signal generator 100 which generates an AC signal for coupling to a buried conductor. The signal generated by the signal generator 100 has two frequencies. A first frequency of 33kHz and a second frequency of 66kHz. The signal generator has a first oscillator 102 which generates an AC signal having a frequency of 33kHz. The first oscillator is connected to a first filter 104 which is configured to allow signals having a frequency of 33 kHz to pass and to attenuate any harmonics produced by the first oscillator. A first terminal 106 is connected to the first filter 104. The signal generator 100 has a second oscillator 108 which generates a signal having a second frequency. In this example, the second frequency is 66kHz. The second oscillator is connected to a second filter 110. The second filter 110 allows signals having a frequency of around 66 kHz to pass and attenuates harmonics. The second filter 110 is connected to a second terminal 112 of the signal generator 100.

The first and second filters may be for example, low pass filters or band-pass filters.

In use, the signal generator 100 is coupled to a buried conductor by the first terminal 106 and the second terminal 112. The output of the signal generator 100 may be directly connected to the buried conductor. In this case, one of the terminals is connected directly to the pipe or cable at an access point such as a valve, meter or end of the conductor and the circuit is completed by a connection of the other terminal to a ground stake or other ground connection point.

The signal generator 100 thus provides a method of generating a signal having two frequencies in a buried conductor.

Fig. 2 illustrates a schematic diagram of a signal generator 200 for generating a signal having two frequencies. In this embodiment, a controller 202 provides a first waveform having a first frequency and a second waveform having a second frequency. The controller 202 is a complex programmable logic device (CPLD). The first waveform is fed through an amplifier 204 and through a filter 206 to a first terminal 208. The controller 202 also produces a second waveform having a second frequency this is fed through a second amplifier 210 and a second filter 212 to a second terminal 214. The amplifiers 204 and 210 are each formed from a driver 216 which drives two switching devices 218 and 220. The switching devices 218 and 220 are arranged in a half bridge formation.

In use, the controller 202 generates waveforms at a first frequency of 33 kHz and a second frequency of 66 kHz. The waveforms are each selected to suppress signal components at a third harmonic frequency of their fundamental frequency. This waveform is then used by the driver 216 to cause the switching devices 218 and 220 to switch the input of the filter between ground reference and a supply voltage. The filter attenuates harmonics that are present in the waveforms. For example, therefore the filter 206 blocks frequencies other than 33 kHz. Because the driving waveform for the first amplifier 204 is selected to suppress the third harmonic frequency, the largest element that the filter 206 has to block is the fifth harmonic frequency of 33kHz.

When a load is connected between the terminals 208 and 214 the current returns to ground reference through the opposite filter. The impedances of the components of the filters are selected so that the impedance to ground reference of the second filter 212 for a frequency of 33kHz (the frequency emitted from the first terminal 208) is low and impedance to the ground reference of the first filter 206 for a frequency of 66kHz is low.

In the embodiment described above, the half-bridges are controlled by a CPLD. Digital logic (e.g. CMOS), a microcontroller, FPGA, or other digital processors could be used in place of the CPLD. In an alternative embodiment, the oscillators controlling the half-bridges could be provided from a pair of crystal oscillator circuits running independently of one another.

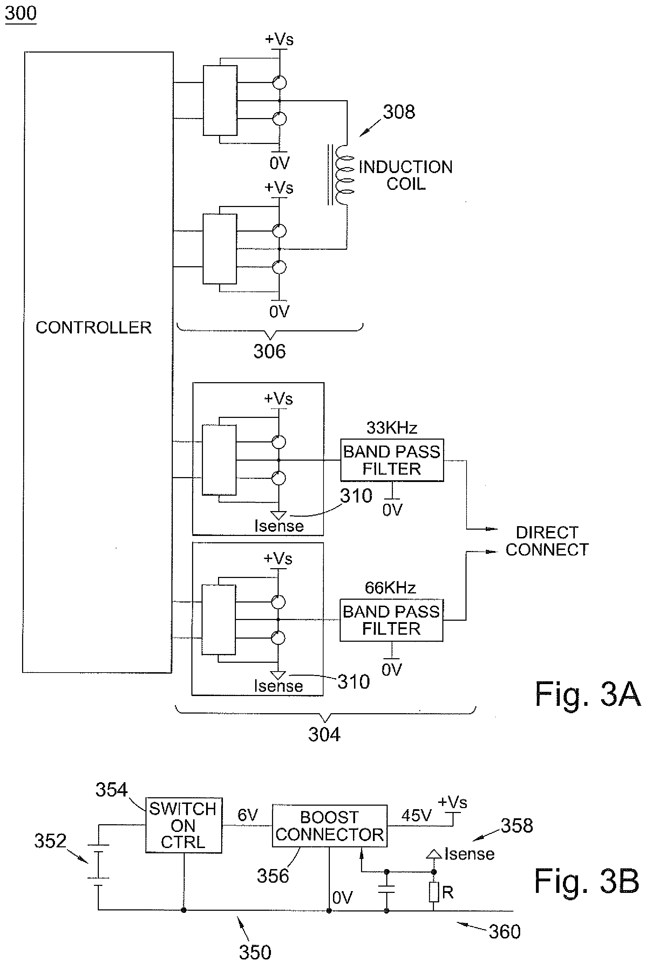

Fig. 3A illustrates an embodiment of a signal generator 300 for coupling to a conductor and generating and an alternating current having two frequencies in the conductor. The signal generator 300 has a controller 302 which controls two signal generating elements. There is a signal generating element for direct connecting 304 which is analogous to the circuit described in relation to Fig. 2. The signal generator 300 also has an inductive signal generator 306. The inductive signal generator includes an induction coil 308 which is driven by four switching elements in an H bridge formation. To generate a signal having a first frequency and a second frequency, the controller generates a drive waveform having the first and second frequencies. This drive waveform is used to drive the switching elements in the inductive signal generator 306 and cause the current through the induction coil 308 to vary according to the time integral of the drive waveform.

A current sense point 310 on each of the half bridges is connected to a power supply of the signal generator to regulate the supply voltage if the current between the terminals becomes higher than a threshold.

The power supply 350 is shown in Fig. 3B. The power supply comprises a battery 352. The battery 352 is connected to a switch on control 354. The battery provides a voltage of 6V to a boost converter 356. The boost converter 356 provides the source voltage for the half bridges and H-bridge shown in Fig. 3A. The current sense point 352 is connected to an input of the boost converter 356 and a low pass filter 360. When the current sensed at the current sense points 310 exceeds a threshold the boost converter lowers the supply voltage this regulates the magnitude of the current through the load.

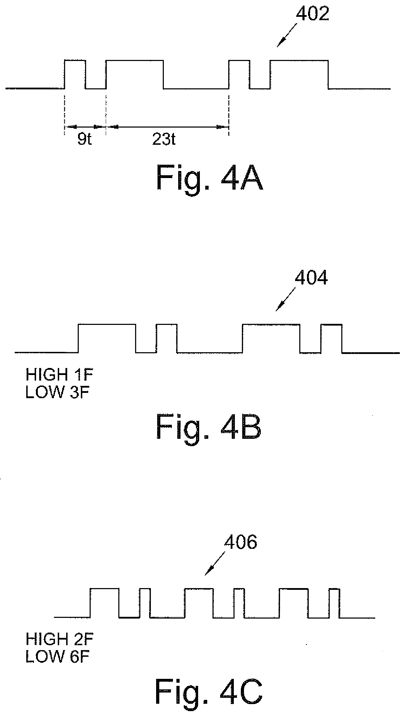

Fig. 4A illustrates an example of the waveform 402 used to drive the induction coil 308. The waveform 402 is a rectangular waveform with containing pulses having a 9:23 ratio in duration. Such a waveform has been found to produce first and second frequency components where one frequency is twice the other frequency.

Fig. 4B illustrates an example of the waveform 404 used to drive the 33kHz part of the direct connect circuit 304. The waveform 404 has a high component in F=33kHz and a low component in the third harmonic frequency 3F.

Fig. 4C illustrates an example of the waveform 406 used to drive the 66kHz part of the direct connect circuit 304. The waveform 406 has a high component in 2F=66kHz and a low component in the third harmonic frequency 6F.

It is noted that the inductive signal generator 306 is non-resonant. This means that it can generate signals of two different frequencies efficiently. Signal generators for inductively generating a signal in a conductor often comprise a resonant circuit. Such a resonant circuit is effective for generating an alternating current at a frequency close to the resonant frequency of the resonant circuit. However, a resonant circuit is not efficient at generating frequencies outside the resonant frequency bandwidth of the resonant circuit. This means that to generate alternating currents having two frequencies for example 33kHz and 66kHz, either a resonant circuit with a broad resonant frequency bandwidth (i.e. a low Q-factor) would have to be used, or the resonant circuit would have to be driven at frequencies a long way from its resonance. Either case would result in an inefficient energy transfer.

For the Signal Generator, the direct-connection output system described above provides the best power efficiency simultaneously with the best signal quality (lowest harmonic content) over the entire load impedance range from zero ohms towards infinity. Best power efficiency is obtained using class D switching amplifiers. Class B amplifiers have theoretical maximum power efficiency of 78% (= pi over 4) at best when amplifying a sinusoidal waveform. Class D improves on this with a theoretical power efficiency limit of 100%. The imperfections of class D are mainly due to switching losses, which become greater as the switching frequency increases, due to repeatedly charging and discharging capacitances in the switching components, resulting in real-world power efficiency of less than 100%. Filtering the output of the switching stage to prevent unwanted switching noise being coupled to the load further reduces power efficiency due to resistive losses in non-ideal inductors and capacitors. To use uniformly sampled class D PWM requires a switching frequency of at least 10 times and preferably at least 20 times the highest signal frequency. In the present application, a highest signal frequency of 66kHz would necessitate a switching frequency of at least 660kHz and preferably at least 1.32MHz. This will result is relatively high switching losses in a Class D amplifier. Such an amplifier would be little better than a class B amplifier.

A more power efficient implementation is embodied by the signal generator described above. By switching a half-bridge at the signal frequency the switching loss in the half-bridge is minimized. Use of a switching waveform that eliminates the third harmonic of the fundamental switching frequency of the half-bridge simplifies the output filter design, since the lowest harmonic frequency requiring attenuation is that of the 5^{th} harmonic. Combining two such half-bridge circuits, the first operating at a first frequency (33kHz) and the second operating at a second frequency (66kHz) results in a system having minimal power loss, hence maximizing battery life in a portable battery operated signal generator. The signal purity (freedom from unwanted harmonics and noise) is also exemplary.

A locator, or detector for locating conductors carrying an alternating current of two or more frequencies will now be described.

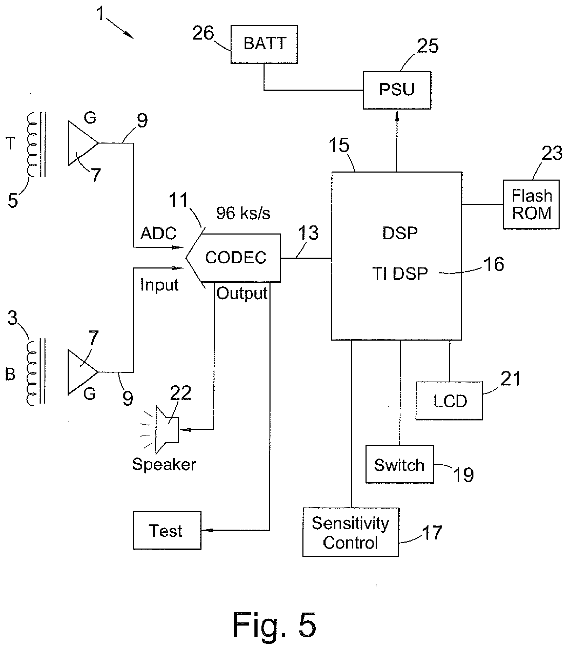

Referring to Fig. 5, a detector 1 has two vertically spaced antennae, namely a bottom antenna 3 and a top antenna 5 within an elongate vertically held housing (not shown) configured to be moveable manually by an operator using a handle. The antennae 3, 5 are arranged with their axes parallel and spaced apart so that in use the bottom antenna 3 will be directly below the top antenna 5, their axes being horizontal. Each antenna 3, 5 produces an electrical signal which is fed into a respective one of two amplifiers 7. The amplifier outputs are field strength signals 9 which are fed into a CODEC 11.

Each of the antennae 3, 5 has a noise floor. Each electrical signal from the antennae 3, 5 is fed to its respective amplifier 7 to lift the noise floor of the magnetic sensor above an intrinsic quantization noise floor of the CODEC 11. The output of each amplifier 7 is fed into the CODEC 11.

The antennae 3, 5 used are high sensitivity wound ferrite rods. Other magnetic sensors may be used such as Hall effect sensors, flux gate magnetometers, or giant magneto resistance sensors.

The CODEC 11 is a 24-bit stereo delta-sigma analogue to digital converter (ADC). This is a relatively cheap device which is commonly used in the audio industry. In Radiodetection Limited's product marketed under the 'RD4000 (RTM)' trade mark, pre-selective filtering, multiple switch gain stages and a phase sensitive heterodyne circuit are used between the antennae and the ADC. In other prior art cable detectors, more sophisticated and consequently more expensive ADCs are used, as the absolute accuracy of the device measurements is important.

The CODEC 11 used in this embodiment has an absolute accuracy of ±5%, however the way that the CODEC 11 is used makes it an ideal ADC for this application. High dynamic range negates the requirement for multiple gain stages. The high dynamic range is achieved by massively oversampling the bandwidth of detection - the noise shaping aspect of the audio CODEC 11 being an ideal application for this principal.

Notwithstanding the poor absolute accuracy of this audio-grade stereo ADC, the present embodiment benefits from the fact that the detector 1 calculates the depth of a buried conductor by processing and comparing the signals received from the two antennae 3, 5. Therefore, any absolute inaccuracy in the sampling of the CODEC 11 is overcome by comparing the two processed signals. Using this CODEC 11 as a ratiometric device provides a significant cost reduction, without compromising overall performance of the detector 1.

The CODEC 11 oversamples the field strength signals 9 at up to 96KHz. The output 13 of the CODEC 11 is fed into a digital signal processing block 15, which is comprised of a digital signal processor 16 (DSP).

The DSP 16 primarily has three tasks. Firstly, it is responsible for defining the selectivity of the detection frequency bands. Secondly, it manages the audio and visual outputs of the detector. Thirdly, it provides general control functions to other components of the detector 1.

More details of the operation of the DSP's tasks are provided in Radiodetection Limited's applications published as WO 03/071311, WO 03/069598, WO 03/069769, GB 2400994, and GB 2400674.

Significant benefits are derived from ultra-narrow bandwidth processing, noise typically scaling with the square of bandwidth. The detector 1 processes in several frequency bands simultaneously, allowing ballistic response functions, such as the general locate task, to co-exist with narrow bandwidth functions, such as depth computation. The depth computation task computes in a 1 Hz bandwidth at any frequency up to 44kHz, the out-of-band rejection being around -120dB.

Phase tracking allow the narrows bandwidth tasks to lock-on to the carrier frequency when the potential frequency error between transmitter and receiver clocks is in excess of the signal bandwidth. In the case of the active mode, the transmitted signal may be 100% amplitude modulated and the depth calculation task has to position itself exactly on the carrier without cross-talk from the side-bands (located at ±6Hz around the 32,768 Hz carrier).

The phase tracking algorithm is a natural development of processes described in Radiodetection Limited's UK Patent Application No. 0407372.2. Signal to noise ratio (SNR) measurements are made on the carrier and side-bands and checks performed to ensure the tracking algorithm does not wander off on any high order harmonics due to power-line transmissions. SNR is quantified from both magnitude and second derivative phase information; all results are correlated from both antennae 3, 5. In the case of an SNR less than 10dB, the depth calculation task is disabled, thus ensuring only accurate information is presented to the user.

The concept of spectral recognition is applied to the active signal when it is in pulsed mode operation. This idea is a simple application of the algorithms described in Radiodetection Limited's UK Patent Application No. 0407372.2 and involves a spectral assessment of the carrier and AM side-bands. The assessment is a Discrete Fourier Transform (DFT) convolution and measurement of the SNR. The DFT itself moves with the tracking algorithm and locks on to the carrier frequency.

The combination of these methods ensures that the detector 1 achieves the best possible signal integrity and depth accuracy.

User control of the detector 1 is provided by means of a sensitivity control 17 and a switch 19. The switch 19 is used to set the mode of operation of the detector 1. For example, the detector 1 can be set to operate in radio, power or active mode. The active mode is chosen when a dedicated signal generator is used in proximity to the cable which is to be detected, the signal generator inducing an alternating current in the conductor which re-radiates a magnetic signal. The signal generator operates at a preset frequency and with a preset modulation which is identified by the detector 1. A further position of the switch 19 is 'avoidance' mode, the operation of which is explained below.

The sensitivity control 17 is used to vary the gradient sensitivity of the antennae 3, 5. High sensitivity is initially used to detect the presence of a weak signal produced by a current carrying conductor. Once the presence of a conductor has been established, the sensitivity control 17 is varied to decrease the sensitivity of the detector 1 and the detector 1 is used to more precisely determine the location of the concealed current carrying conductor. This method of profiling the locate window as a function of sensitivity is described in U.S. Patent No. 6,777,923 to Radiodetection Limited.

A liquid crystal display (LCD) 21 is provided in the housing surface to display such information as the mode of operation of the detector, the battery status, the depth of a conductor and/or the strength of the detected signal. Other user display devices can be used, as will be apparent to the skilled person.

The detector 1 also comprises a flash ROM 23, in which software is stored, and a power supply unit (PSU) 25. A key requirement of the detector 1 is that it must be portable. Therefore, batteries 26 are used to power the detector 1, in this case two 'D'-type batteries, each providing a nominal 1.5V.

In use, the detector 1 is powered up and software is loaded from the flash ROM 23 into the digital signal processing block 15. A user adjusts the switch 19 to select the mode of operation. The selection will be either radio mode, power mode, active mode, or avoidance mode. A depth threshold alarm function is active in power mode, active mode and avoidance mode. In avoidance mode the depth threshold alarm function operates on frequencies in the frequency bands of power mode and active mode. The depth threshold alarm function is detailed below.

When the detector 1 is in proximity to a current carrying conductor, a current is induced in the bottom and top antennae 3, 5. The current induced in each of the antennae 3, 5 is amplified by a respective amplifier 7. The outputs 9 from the amplifiers 7 are field strength signals of the two antennae 3, 5. These signals are input to the CODEC 11 which samples these signals at up to 96 kilo samples per second. The digitized signals 13 are fed to the digital signal processing block 15. The DSP 16 of the digital signal processing block 15 isolates signals of target frequency bands, depending on the mode of operation. If the DSP detects the presence of a current carrying conductor an audio and/or visual alarm is triggered on the speaker 22 and/or indicator 21.

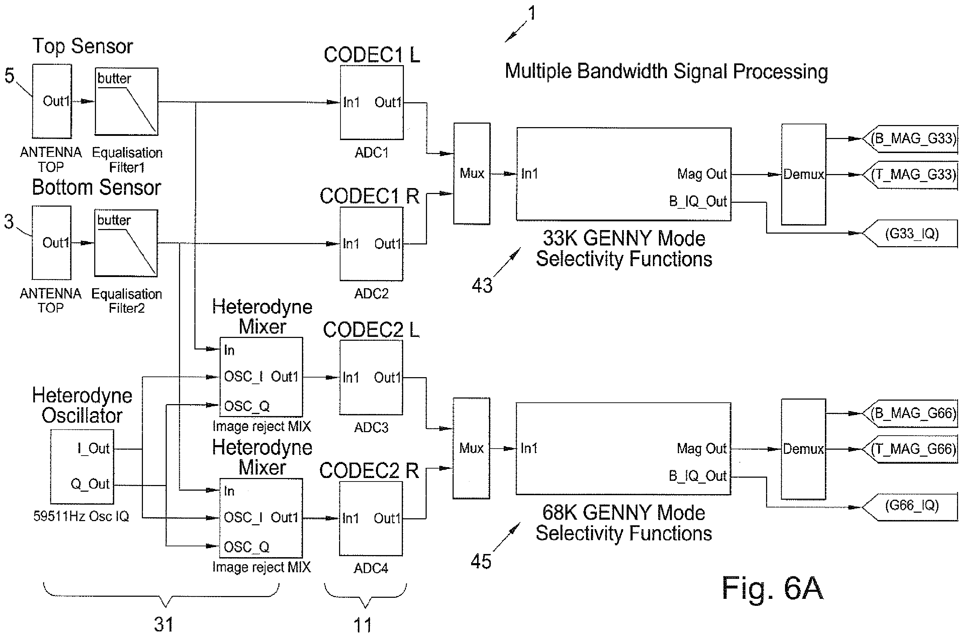

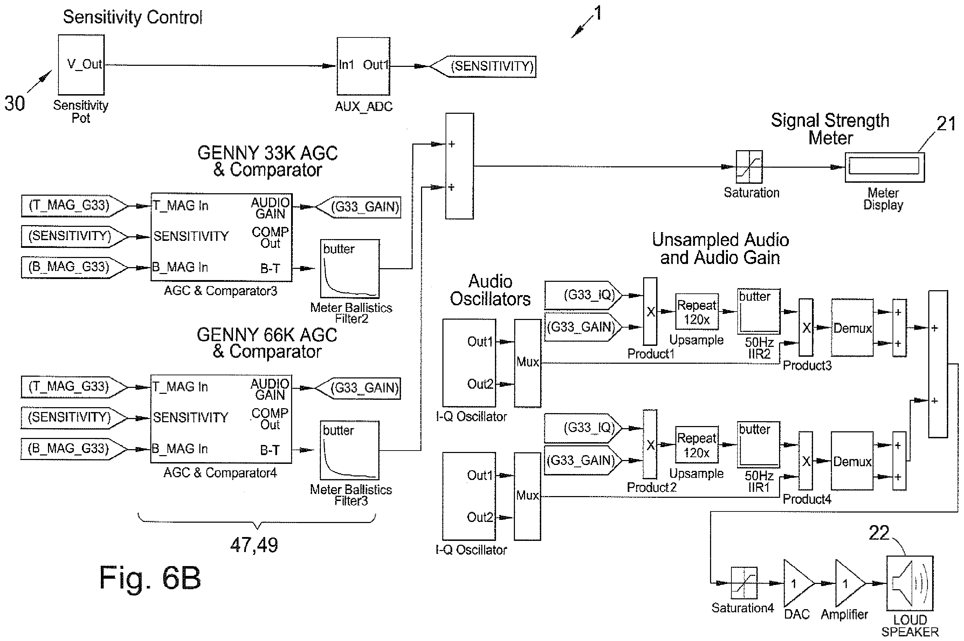

Figs. 6A and 6B illustrate a more detailed block diagram of the detector 1 showing the dual frequency mode system, which is implemented in the detector 1. As mentioned above, two frequencies 33kHz and 66kHz are induced in the conductor being detected.

The detector 1 of this embodiment processes the two frequencies of 33kHz and 66kHz simultaneously. The pair of antennae 3, 5 receive signal components of both frequencies. The system also has a common detection indicator 21 and speaker 22 which provide an indication of the depth of the buried conductor calculated from both of the frequency components. The detection sensitivity 30 is normally set to maximum, but can be set at a lower level.

The stereo CODECs 11 are clocked at 73.242 KHz. In order to process the 66KHz signal, using such a CODEC, a heterodyne system 31 of a heterodyne oscillator and two heterodyne mixers is used to convert the 66Khz signal into an intermediate frequency 6KHz signal. As shown in Fig. 6a, an oscillator with a frequency of approximately 60KHz is used, and the heterodyne mixers reject the signal resulting from the sum of the 60KHz oscillator and the 66KHz signal and pass only the difference signal having a frequency of approximately 6 KHz. This is within the Nyquist frequency range of the ADC. The DSP 16 processes the field strength signals produced by the antennae 3, 5 and simultaneously isolates signals of each of the two frequency bands in two mode selectivity functions 43, 45.

In an alternative embodiment, the heterodyne system 31 is omitted and an analogue digital converter having a higher sample rate which places the Nyquist frequency above 66KHz is used.

Signal outputs from the DSP 16 corresponding to the different frequencies are fed into automatic gain controllers 47 (AGCs), such as the AGC described in U.S. Patent No. 6,777,923 to Radiodetection Limited. The output of each of the AGCs 47 is converted to a detection signal in comparators 49. The detection signals are combined and used to provide an audio output from a speaker 22 and/or a visual signal on an indicator 21, for example on the LCD.

The detector 1 continually calculates the estimated depth of a buried conductor. If the depth of a buried conductor is calculated as less than a preset threshold, e.g. 30cm, an audio and/or visual alarm may be triggered to alert the operator of a shallow conductor. Such shallow conductors are of particular interest as there is an increased risk of hitting a shallow conductor when excavating an area.

In order to optimize the user interface of the detector, when calculating the depth of a conductor, the DSP 16 processes signals in two frequency bands simultaneously to tailor the manner in which information is presented to the user. The depth of the conductor is calculated in a 1Hz bandwidth; the visual display is processed in a 10Hz bandwidth so that the flicker of the display is at an acceptable level; and the processing of the audio alert is performed at 35Hz, to ensure that the pulsing tone is clearly audible.

Embodiments of the disclosed subject matter may be implemented in combination with a depth threshold alarm, and/or with an 'avoidance mode' as described in UK Patent Application No. 2427473.

While in the embodiments described above, the two frequencies are induced in a conductor by a single signal generator, embodiments of the disclosed subject matter are envisaged in which the two signals are generated by different signal generators. Indeed embodiments of a locator are envisaged in which the different frequencies are induced in different conductors, for example with a different frequency being induced in different types of utility. In such an embodiment, the locator may provide an indication of which frequency is dominant, thereby giving an indication of the utility which is present.

The digital domain signal processing may be implemented in FPGA, DSP, or microcontroller devices, or split across some combination of the aforementioned devices.

Aspects of the disclosed subject matter can be implemented in any convenient form, for example using dedicated hardware, or a mixture of dedicated hardware and software for the processing of the signals. The processing apparatuses can comprise any suitably programmed apparatuses such as a general purpose computer, personal digital assistant, mobile telephone (such as a WAP or 3G-compliant phone) and so on. Since the processing of the disclosed subject matter can be implemented as software, each and every aspect of the disclosed subject matter thus encompasses computer software implementable on a programmable device. Hence, aspects of the disclosed subject matter can be executed on a programmable machine, such as, but not limited to, a microcontroller or computer processor. Program aspects of the technology may be thought of as "products" or "articles of manufacture" typically in the form of executable code and/or associated data that is carried on or embodied in a type of machine readable medium. "Storage" type media include any or all of the memory of mobile stations, computers, processors or the like, or associated modules thereof, such as various semiconductor memories, tape drives, disk drives and the like, which may provide storage at any time for the software programming. All or portions of the software may at times be communicated through the Internet or various other telecommunication networks. Such communications, for example, may enable loading of the software from one computer or processor into another computer or processor. For example, software and/or instructions may be communicated from a server to a client. Thus, another type of media that may bear the software elements includes optical, electrical, and electromagnetic waves, such as used across physical interfaces between local devices, through wired and optical landline networks and over various air-links. The physical elements that carry such waves, such as wired or wireless links, optical links or the like, also may be considered as media bearing the software. As used herein, unless restricted to tangible "storage" media, terms such as computer or machine "readable medium" refer to any medium that participates in providing instructions to a processor for execution.

Hence, a machine readable medium may take many forms, including but not limited to, a tangible storage medium, a carrier wave medium or physical transmission medium. Non-volatile storage media include, for example, optical or magnetic disks, such as any of the storage devices in any computer(s) or the like, such as may be used to implement the subject matter described in this application. Volatile storage media include dynamic memory, such as main memory of such a computer platform. Tangible transmission media include coaxial cables; copper wire, and fiber optics, including the wires that comprise a bus within a computer system. Carrier-wave transmission media can take the form of electric or electromagnetic signals, or acoustic or light waves such as those generated during radio frequency (RF) and infrared (IR) data communications. Common forms of computer-readable media therefore include for example: a floppy disk, a flexible disk, hard disk, magnetic tape, any other magnetic medium, a CD-ROM, DVD or DVD-ROM, any other optical medium, punch cards paper tape, any other physical storage medium with patterns of holes, a RAM, a PROM and EPROM, a FLASH-EPROM, any other memory chip or cartridge, a carrier wave transporting data or instructions, cables or links transporting such a carrier wave, or any other medium from which a computer can read programming code and/or data. Many of these forms of computer readable media may be involved in carrying one or more sequences of one or more instructions to a processor for execution

It is to be understood that any feature described in relation to any one aspect may be used alone, or in combination with other features described, and may also be used in combination with one or more features of any other of the disclosed aspects, or any combination of any other of the disclosed aspects.

## Claims

1. A signal generator (100) arranged to directly couple an alternating electrical current into a buried conductor, the signal generator comprising:
a first oscillator (102) configured to generate a first waveform having a first frequency,
a first terminal (106) coupled to the first oscillator (102) through a first filter (104) configured to pass signals of the first frequency to the first terminal (106);
a second oscillator (108) configured to generate a second waveform having a second frequency;
a second terminal (112) coupled to the second oscillator (108) through a second filter (110) configured to pass signals of the second frequency to the second terminal (112); and
a connector for connecting one of the first and second terminals (106, 112) to the buried conductor and for connecting the other of the first and second terminals (106, 112) to a ground connection point.

2. A signal generator (100) according to claim 1 wherein the second frequency is a harmonic of the first frequency and / or the second frequency is twice the first frequency.

3. A signal generator (100) according to any preceding claim wherein the first waveform is selected to suppress a third harmonic frequency of the first frequency.

4. A signal generator (100) according to any preceding claim further comprising a power supply (350) which provides a supply voltage and a ground reference voltage for the first and second oscillators (102, 108).

5. A signal generator (100) according to claim 4, wherein the first and/or second oscillator (102, 108) comprises a current sensor (310) and the power supply (350) is configured to reduce the supply voltage if a current detected by the current sensor (310) exceeds a predetermined value.

6. A signal generator (100) according to any preceding claim further comprising a first amplifier (204) configured to amplify the first waveform and a second amplifier (210) configured to amplify the second waveform.

7. A signal generator (100) according to claim 6, wherein the first amplifier (204) and/or the second amplifier (210) comprise two switching devices (218, 220) arranged in a half-bridge formation.

8. A signal generator (100) according to claim 7, wherein the switching devices (218, 220) are MOSFET devices.

9. A signal generator (100) according to any one of claims 6 to 8, wherein the first and second oscillators (102, 108) are provided by a controller (202) which is configured to generate the first waveform and the second waveform.

10. A signal generator (100) according to any preceding claim wherein the first filter (104) is configured to provide a path to a or the ground reference voltage from the first terminal (106) for a signal of the second frequency and / or the second filter (110) is configured to provide a path to a or the ground reference voltage from the second terminal (112) for a signal of the first frequency.

11. A signal generator (100) according to any preceding claim wherein the first and/or second filter (104, 110) is a band pass filter.

12. A signal generator (100) according to any preceding claim further comprising an inductive coupler for coupling the first and second terminals (106, 112).

13. A signal generator (100) according to any preceding claim, further comprising an induction coil (308) for inductively coupling with the buried conductor and a switching circuit configured to vary the current in the induction coil (308) according to a switching waveform having a first component in the first frequency and a second component in the second frequency.

14. A signal generator (100) according to claim 13, wherein the switching circuit comprises four switching devices in an H-bridge formation.

## Patentansprüche

1. Signalerzeuger (100), der angeordnet ist, um einen elektrischen Wechselstrom direkt in einen erdverlegten Leiter zu koppeln, wobei der Signalerzeuger umfasst:
einen ersten Oszillator (102), der so konfiguriert ist, dass er eine erste Wellenform erzeugt, die eine erste Frequenz aufweist, einen ersten Anschluss (106), der über einen ersten Filter (104) mit dem ersten Oszillator (102) gekoppelt ist, der so konfiguriert ist, dass er Signale der ersten Frequenz an den ersten Anschluss (106) weiterleitet;
einen zweiten Oszillator (108), der so konfiguriert ist, dass er eine zweite Wellenform erzeugt, die eine zweite Frequenz aufweist;
einen zweiten Anschluss (112), der über einen zweiten Filter (110) mit dem zweiten Oszillator (108) gekoppelt ist, der so konfiguriert ist, dass er Signale der zweiten Frequenz zum zweiten Anschluss (112) weiterleitet; und
einen Verbinder zum Verbinden des ersten oder des zweiten Anschlusses (106, 112) mit dem erdverlegten Leiter und zum Verbinden des anderen Anschlusses (106, 112) mit einem Masseverbindungspunkt.

2. Signalerzeuger (100) nach Anspruch 1, wobei die zweite Frequenz eine Oberschwingung der ersten Frequenz ist und/oder die zweite Frequenz das Doppelte der ersten Frequenz beträgt.

3. Signalerzeuger (100) nach einem der vorhergehenden Ansprüche, wobei die erste Wellenform so gewählt ist, dass eine dritte harmonische Frequenz der ersten Frequenz unterdrückt wird.

4. Signalerzeuger (100) nach einem der vorhergehenden Ansprüche, ferner umfassend eine Stromversorgung (350), die eine Versorgungsspannung und eine Massebezugsspannung für den ersten und zweiten Oszillator (102, 108) bereitstellt.

5. Signalerzeuger (100) nach Anspruch 4, wobei der erste und/oder zweite Oszillator (102, 108) einen Stromsensor (310) umfasst und die Stromversorgung (350) so konfiguriert ist, dass sie die Versorgungsspannung reduziert, wenn ein vom Stromsensor (310) erfasster Strom einen vorgegebenen Wert überschreitet.

6. Signalerzeuger (100) nach einem der vorhergehenden Ansprüche, ferner umfassend einen ersten Verstärker (204), der so konfiguriert ist, dass er die erste Wellenform verstärkt, und einen zweiten Verstärker (210), der so konfiguriert ist, dass er die zweite Wellenform verstärkt.

7. Signalerzeuger (100) nach Anspruch 6, wobei der erste Verstärker (204) und/oder der zweite Verstärker (210) zwei Schaltvorrichtungen (218, 220) umfassen, die in einer Halbbrückenanordnung aufgebaut sind.

8. Signalerzeuger (100) nach Anspruch 7, wobei die Schaltvorrichtungen (218, 220) MOSFET-Vorrichtungen sind.

9. Signalerzeuger (100) nach einem der Ansprüche 6 bis 8, wobei der erste und der zweite Oszillator (102, 108) von einem Controller (202) bereitgestellt werden, der so konfiguriert ist, dass er die erste Wellenform und die zweite Wellenform erzeugt.

10. Signalerzeuger (100) nach einem der vorhergehenden Ansprüche, wobei der erste Filter (104) so konfiguriert ist, dass er vom ersten Anschluss (106) einen Pfad zu einer oder der Massebezugsspannung für ein Signal der zweiten Frequenz bereitstellt, und/oder der zweite Filter (110) so konfiguriert ist, dass er vom zweiten Anschluss (112) einen Pfad zu einer oder der Massebezugsspannung für ein Signal der ersten Frequenz bereitstellt.

11. Signalerzeuger (100) nach einem der vorhergehenden Ansprüche, wobei der erste und/oder zweite Filter (104, 110) ein Bandpassfilter ist.

12. Signalerzeuger (100) nach einem der vorhergehenden Ansprüche, der ferner einen induktiven Koppler zum Koppeln des ersten und zweiten Anschlusses (106, 112) umfasst.

13. Signalerzeuger (100) nach einem der vorhergehenden Ansprüche, ferner umfassend eine Induktionsspule (308) zur induktiven Kopplung mit dem erdverlegten Leiter und einen Schaltkreis, der so konfiguriert ist, dass er den Strom in der Induktionsspule (308) gemäß einer Schaltwellenform variiert, die in der ersten Frequenz eine erste Komponente und in der zweiten Frequenz eine zweite Komponente aufweist.

14. Signalerzeuger (100) nach Anspruch 13, wobei der Schaltkreis vier Schaltvorrichtungen in einer H-Brückenanordnung umfasst.

## Revendications

1. Générateur de signaux (100) agencé pour coupler directement un courant électrique alternatif dans un conducteur enterré, le générateur de signaux comprenant :
un premier oscillateur (102) configuré pour générer une première forme d'onde ayant une première fréquence, une première borne (106) couplée au premier oscillateur (102) à travers un premier filtre (104) configuré pour transmettre des signaux de la première fréquence à la première borne (106) ;
un second oscillateur (108) configuré pour générer une seconde forme d'onde ayant une deuxième fréquence ;
une seconde borne (112) couplée au second oscillateur (108) à travers un second filtre (110) configuré pour transmettre des signaux de la deuxième fréquence à la seconde borne (112) ; et
un connecteur pour connecter l'une des première et seconde bornes (106, 112) au conducteur enterré et pour connecter l'autre des première et seconde bornes (106, 112) à un point de connexion à la terre.

2. Générateur de signaux (100) selon la revendication 1, la deuxième fréquence étant une harmonique de la première fréquence et/ou la deuxième fréquence étant le double de la première fréquence.

3. Générateur de signaux (100) selon l'une quelconque des revendications précédentes, la première forme d'onde étant sélectionnée pour supprimer une troisième fréquence harmonique de la première fréquence.

4. Générateur de signaux (100) selon l'une quelconque des revendications précédentes, comprenant en outre une alimentation électrique (350) qui fournit une tension d'alimentation et une tension de référence de terre pour les premier et second oscillateurs (102, 108).

5. Générateur de signaux (100) selon la revendication 4, le premier et/ou le second oscillateur (102, 108) comprenant un capteur de courant (310) et l'alimentation électrique (350) étant configurée pour réduire la tension d'alimentation si un courant détecté par le capteur de courant (310) dépasse une valeur prédéterminée.

6. Générateur de signaux (100) selon l'une quelconque des revendications précédentes, comprenant en outre un premier amplificateur (204) configuré pour amplifier la première forme d'onde et un second amplificateur (210) configuré pour amplifier la seconde forme d'onde.

7. Générateur de signaux (100) selon la revendication 6, le premier amplificateur (204) et/ou le second amplificateur (210) comprenant deux dispositifs de commutation (218, 220) agencés en une formation en demi-pont.

8. Générateur de signaux (100) selon la revendication 7, les dispositifs de commutation (218, 220) étant des dispositifs MOSFET.

9. Générateur de signaux (100) selon l'une quelconque des revendications 6 à 8, les premier et second oscillateurs (102, 108) étant fournis par un dispositif de commande (202) qui est configuré pour générer la première forme d'onde et la seconde forme d'onde.

10. Générateur de signaux (100) selon l'une quelconque des revendications précédentes, le premier filtre (104) étant configuré pour fournir un chemin vers une ou la tension de référence de terre à partir de la première borne (106) pour un signal de la deuxième fréquence et/ou le second filtre (110) étant configuré pour fournir un chemin vers une ou la tension de référence de terre à partir de la seconde borne (112) pour un signal de la première fréquence.

11. Générateur de signaux (100) selon l'une quelconque des revendications précédentes, le premier et/ou le second filtres (104, 110) étant un filtre passe-bande.

12. Générateur de signaux (100) selon l'une quelconque des revendications précédentes, comprenant en outre un coupleur inductif pour coupler les première et seconde bornes (106, 112).

13. Générateur de signaux (100) selon l'une quelconque des revendications précédentes, comprenant en outre une bobine d'induction (308) destinée à coupler par induction le conducteur enterré et un circuit de commutation configuré pour faire varier le courant dans la bobine d'induction (308) selon une forme d'onde de commutation ayant une première composante dans la première fréquence et une seconde composante dans la deuxième fréquence.

14. Générateur de signaux (100) selon la revendication 13, le circuit de commutation comprenant quatre dispositifs de commutation en une formation en pont en H.
